# EUROPÄISCHE PATENTSCHRIFT

(11) **EP 1 222 664 B1**
(45) Veröffentlichungstag und Bekanntmachung des Hinweises auf die Patenterteilung: **07.05.2003**
(21) Anmeldenummer: 00984820.1
(22) Anmeldetag: 04.10.2000
(51) Int. Cl.: G11C 29/00

(54) **VERFAHREN ZUR IDENTIFIZIERUNG EINER INTEGRIERTEN SCHALTUNG**
METHOD FOR IDENTIFYING AN INTEGRATED CIRCUIT
PROCEDE D'IDENTIFICATION D'UN CIRCUIT INTEGRE

(30) Priorität: 22.10.1999 DE 19951048
(43) Veröffentlichungstag der Anmeldung: 17.07.2002
(73) Patentinhaber: Infineon Technologies AG, 81669 München (DE)
(72) Erfinder: HARTMANN, Ralf, 81377 München (DE)
(74) Vertreter: Graf Lambsdorff, Matthias, Dr.
(86) Internationale Anmeldenummer: DE0003513
(87) Internationale Veröffentlichungsnummer: WO01029843

(56) Entgegenhaltungen:
- EP-A- 0 849 675
- US-A- 5 732 207
- US-A- 5 852 712

## Beschreibung

Die Erfindung betrifft ein Verfahren zur Identifizierung einer integrierten Schaltung, insbesondere zur Verknüpfung der integrierten Schaltung mit einem Geräteprogramm.

Halbleiterspeicher sind binäre Datenspeicher, bei denen einzelne Speicherzellen matrixförmig angeordnet sind und aus Halbleiterbauelementen bestehen.

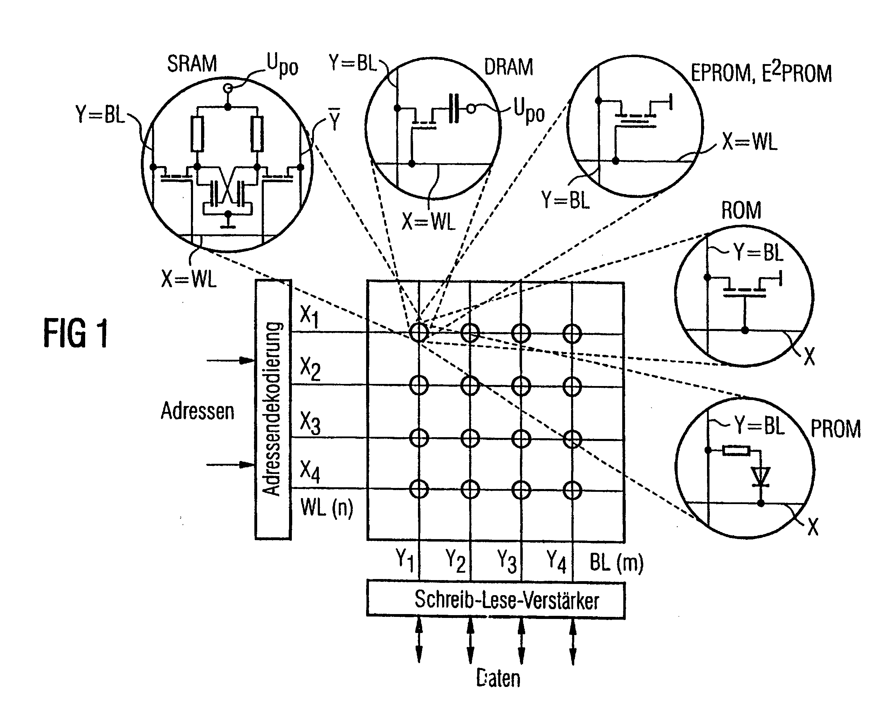

Fig. 1 zeigt den prinzipiellen Aufbau eines Halbleiterspeichers mit verschiedenen Speicherzellen. Die Speicherzellen sind mit Wortleitungen WL über eine Adressen-Decodierschaltung und über Bitleitungen an einen Schreib-Lese-Verstärker angeschlossen. Die Adressierung, d.h. die Auswahl einer Speicherzelle erfolgt durch Aktivierung der Wortleitungen. Die in den Speicherzellen abgespeicherten Informationen werden über einen Leserverstärker ausgelesen oder über einen Schreibverstärker eingeschrieben.

Nach Art der Speicherzellen unterscheidet man folgende Speichertypen, nämlich Speicher mit wahlfreiem Zugriff RAM mit statischen Speicherzellen SRAM oder dynamisch aufladbaren Speicherzellen DRAM. Ferner unterscheidet man Nur-Lesespeicher ROM, programmierbare Nur-Lesespeicher PROM sowie löschbare programmierbare Nur-Lesespeicher EPROM.

In vielen technischen Anwendungsgebieten ist es wünschenswert, daß eine bestimmte Geräte-Software bzw. ein bestimmtes Geräteprogramm nur mit einer bestimmten Hardware ablauffähig ist. Ein Beispiel für ein derartiges technischen Gebiet ist der Mobilfunkbereich. Im Mobilfunkbereich werden die Endgeräte zur Kundenbindung subventioniert. Entscheidet sich ein Kunde für ein subventioniertes Endgerät, so erhält er zusätzlich von dem Netzbetreiber eine Netzbetreiber-Software, durch die das Endgerät fest an den Netzbetreiber gebunden wird. Im Bereich digitaler Mobilfunknetze erfolgt dies beispielsweise durch die SIM-Chipkarte (SIM: Subscriber Identifying Module), die in das Endgerät eingelegt wird. Da die Endgeräte durch den Netzbetreiber subventioniert werden, sind zum Ausgleich in der Regel die Telefonkosten bei diesem Netzbetreiber höher. Durch Laden einer anderen Software, beispielsweise aus einem nicht subventionierten Endgerät, kann die Bindung zwischen dem Endgerät und der Netzbetreiber-Software aufgehoben werden. Um diesen großen wirtschaftlichen Schaden zu vermeiden, wird daher die Netzbetreiber-Software mit dem subventionierten Endgerät fest gekoppelt bzw. zu einer ablauffähigen Software verknüpft. Eine raubkopierte Software ist auf einem derartigen gebundenen Endgerät nicht ablauffähig.

Dies wird bisher dadurch erreicht, daß man eine Seriennummer in einem nicht-flüchtigen Speicher, beispielsweise einem EEPROM-Speicher oder einem Flash-EPROM-Speicher einer in dem Endgerät eingebauten integrierten Schaltung fest abspeichert. Das Abspeichern der Seriennummer erfolgt beim Hersteller der integrierten Schaltung, der diese an den Gerätehersteller liefert. Beim Gerätehersteller wird die abgespeicherte Seriennummer mittels Verschlüsselungsalgorithmen mit der Gerätehersteller-Software derart verknüpft, daß die Gerätehersteller-Software nur mit der in dem Gerät eingebauten integrierten Schaltung zusammen ablauffähig ist.

Die Seriennummer zur Identifizierung der integrierten Schaltung wird dabei nicht in einem gewöhnlichen Speicherbereich der integrierten Schaltung abgespeichert, sondern in einem eigenen besonderen Seriennummernspeicher. Der Grund dafür ist, daß Speicherbausteine leicht erhältliche Standardprodukte sind, so daß durch Kopieren eines Speichers eines nicht gebundenen Geräts und durch Ersatz bzw. Neuprogrammierung des Speichers eines gebundenen Geräts die Sperre des Endgeräts aufgehoben werden könnte. Daher wird die Seriennummer zur Identifizierung der integrierten Schaltung unveränderbar in einem eigenen Seriennummernspeicher abgespeichert. Das Abspeichern der Seriennummer wird beispielsweise durch Fusen bzw. durch festes Verdrahten des Seriennummernspeichers nach der Herstellung der integrierten Schaltung vorgenommen.

Beim Fusen des Seriennummernspeichers wird mittels Strom oder Laser eine logische Funktion des Seriennummernspeichers verändert bzw. dieser Seriennummernspeicher umverdrahtet. Das Abspeichern einer Seriennummer in einem eigenständigen Seriennummernspeicher weist einige schwerwiegende Nachteile auf. Zum einen muß in der integrierten Schaltung ein eigenständiger Seriennummernspeicher integriert werden, wodurch die Herstellungskosten der integrierten Schaltung erhöht werden. Zusätzlich müssen zusätzliche Produktionsanlagen bereitgestellt werden, die den Verdrahtungsprozeß des Seriennummernspeichers durchführen. Die Anschaffung derartiger Anlagen verursacht zusätzliche Kosten. Darüber hinaus verlängert das Fusen bzw. das Programmieren des Seriennummernspeichers zum Abspeichern der Seriennummer die Herstellungszeit der integrierten Schaltung, so daß sich die Produktionszeit insgesamt und somit die Herstellungskosten erhöhen.

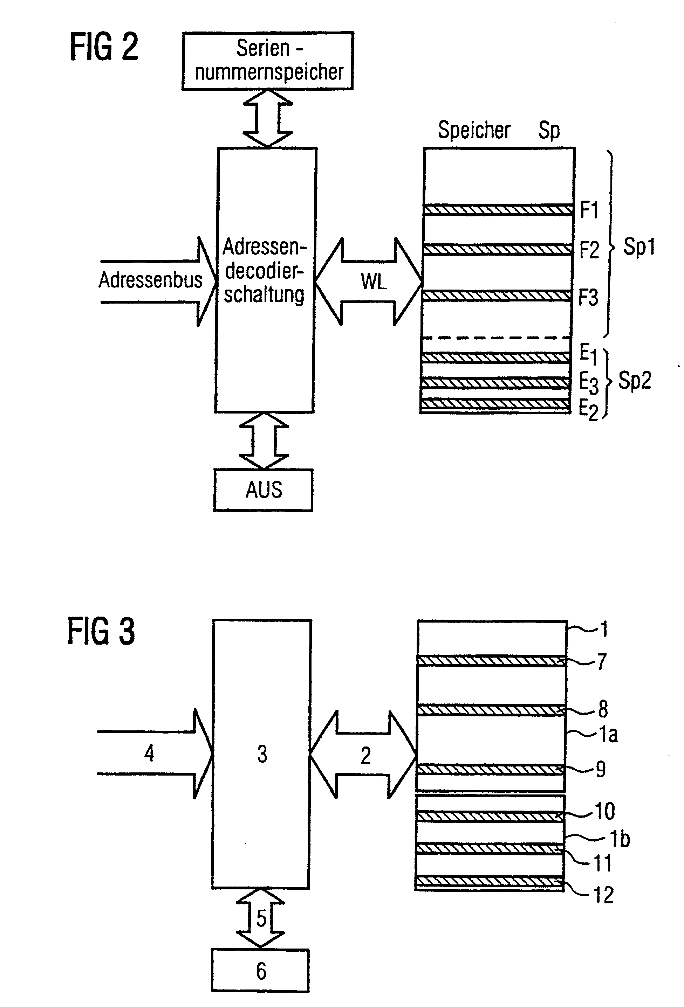

Fig. 2 zeigt den schaltungstechnischen Aufbau zur Identifizierung einer integrierten Schaltung mittels einer Seriennummer, die in einem Seriennummernspeicher fest verdrahtet ist, nach dem Stand der Technik. Die Adressen-Decodierschaltung liegt an dem Adressenbus des Endgeräts an und adressiert über Wortleitungen WL einen Speicher SP mit einem ersten Speicherbereich SP1 und einem redundanten Speicherbereich SP2. Der Speicher SP1 besteht aus einer Vielzahl von Speicherzellen SZ, wobei bei der Herstellung fehlerhafte Speicherzellen entstehen, die in Fig. 2 schraffiert angedeutet sind. Der Speicherbereich SP2 weist eine Vielzahl von redundanten Speicherzellen auf, durch die die fehlerhaften Speicherzellen F1, F2, F3 ersetzt werden können. Hierzu ist die Adressen-Decodierschaltung mit einem Adressenumsetzungsspeicher AUS verbunden. In dem Adressenumsetzungsspeicher wird tabellenförmig zu jeder fehlerhaften Speicherzelle F eine zugehörige Ersatzspeicherzelle E abgespeichert. Ferner ist die in Fig. 2 gezeigte Adressen-Decodierschaltung mit dem Seriennummernspeicher verbunden, in dem die Seriennummer bzw. Identifizierungsnummer der integrierten Schaltung fest verdrahtet abgespeichert ist.

Das Vorsehen des Seriennummernspeichers sowie das Fusen bzw. Programmieren des Seriennummernspeichers zum Abspeichern der Seriennummer der integrierten Schaltung führt, wie oben ausgeführt, zu einer Erhöhung der Produktionszeit und der Herstellungskosten der integrierten Schaltung.

Es ist daher die Aufgabe der vorliegenden Erfindung, ein Verfahren zur sicheren Identifizierung einer integrierten Schaltung zu schaffen, bei der eine Schaltungsidentifizierungsnnummer zur Identifizierung der integrierten Schaltung nicht mehr fest verdrahtet in einem eigenen Speicher abgespeichert werden muß.

Diese Aufgabe wird erfindungsgemäß durch ein Verfahren mit den im Patentanspruch 1 angegebenen Merkmalen gelöst.

Weitere vorteilhafte Ausgestaltungen des erfindungsgemäßen Verfahrens ergeben sich aus den Unteransprüchen.

Die Erfindung schafft ein Verfahren zur Identifizierung einer integrierten Schaltung mit einem aus einer Vielzahl von Speicherzellen bestehenden Speicher, der ein herstellungsbedingtes, aus fehlerhaften Speicherzellen bestehende Speicherzellen-Fehlermuster aufweist, bei dem eine Schaltungsidentifizierungsnummer zur Identifizierung der integrierten Schaltung in Abhängigkeit von dem Speicherzellen-Fehlermuster erzeugt wird.

Bei dem erfindungsgemäßen Verfahren werden vorteilhafterweise die Adressen der fehlerhaften Speicherzellen erfaßt und die Schaltungsidentifizierungsnummer in Abhängigkeit von den erfaßten Adressen der fehlerhaften Speicherzellen erzeugt.

Vorzugsweise besteht die Schaltungsidentifizierungsnummer aus einer oder mehreren Adressen der fehlerhaften Speicherzellen.

Bei einer weiteren vorteilhaften Ausbildung des erfindungsgemäßen Verfahrens wird die Schaltungsidentifizierungsnummer gebildet, indem eine oder mehrere Adressen der fehlerhaften Speicherzellen miteinander in einer mathematischen Verknüpfungsoperation verknüpft werden.

Vorzugsweise wird die Schaltungsidentifizierungsnummer zur Verknüpfung mit einem Geräteprogramm zu einem ablauffähigen Geräteprogramm ausgelesen.

Dabei wird bei einer bevorzugten Weiterbildung das verknüpfte ablauffähige Programm zum Betreiben eines Geräts in einem Programmspeicherbereich abgespeichert.

Die Adressen jeder fehlerhaften Speicherzelle sind vorzugsweise jeweils auf einer Adresse einer Ersatzspeicherzelle in einem redundanten Speicherbereich des Speichers umgeleitet.

Bei einer bevorzugten Ausführungsform des erfindungsgemäßen Verfahrens wird zu jeder Adresse einer fehlerhaften Speicherzelle jeweils die Adresse einer zugehörigen Ersatzspeicherzelle in einem Adressenumsetzungsspeicher als Adressentabelle abgespeichert.

Die Adressen der fehlerhaften Speicherzelle werden bei einer Ausführungsform des erfindungsgemäßen Verfahrens nach der Herstellung der integrierten Schaltung in einem Herstellertestvorgang einmalig erfaßt und mit den Adressen der zugehörigen Ersatzspeicherzellen in dem Adressenumsetzungsspeicher zur Adressenumleitung fest abgespeichert.

Bei einer bevorzugten Ausführungsform des erfindungsgemäßen Verfahrens werden die Adressen der fehlerhaften Speicherzellen bei jedem Einschalten der integrierten Schaltung in einem Selbsttest erfaßt und mit den Adressen der zugehörigen Ersatzspeicherzellen in dem Adressenumsetzungsspeicher zur Adreßumleitung abgespeichert.

Vorzugsweise wird die Schaltungsidentifizierungsnummer in Abhängigkeit von den in dem Selbsttest erfaßten Adressen der fehlerhaften Speicherzellen erzeugt und durch das Geräteprogramm mit der verknüpften ursprünglichen Schaltungsidentifizierungsnummer verglichen, wobei das Geräteprogramm das zugehörige Gerät freischaltet, wenn die nach dem Selbsttest erzeugte Schaltungsidentifizierungsnummer mit der ursprünglichen Schaltungsidentifizierungsnummer identisch ist.

Im weiteren sind bevorzugte Ausführungsformen des erfindungsgemäßen Verfahrens unter Bezugnahme auf die beigefügten Zeichnungen zur Erläuterung erfindungswesentlicher Merkmale beschrieben.

### Es zeigen:

Fig. 1 den prinzipiellen Schaltungsaufbau eines Halbleiterspeichers mit verschiedenen Speicherzellen nach dem Stand der Technik;

Fig. 2 ein Blockschaltbild der Adressen-Decodierung innerhalb einer integrierten Schaltung, zu deren Identifizierung mittels einer in einem Seriennummernspeicher abgespeicherten Seriennummer nach dem Stand der Technik;

Fig. 3 die Adressendecodierung innerhalb einer integrierten Schaltung zu deren Identifizierung mittels des erfindungsgemäßen Verfahrens;

Fig. 4 ein Ablaufdiagramm zur Erläuterung des erfindungsgemäßen Verfahrens.

Fig. 3 zeigt die Speicheradressierung einer integrierten Schaltung zur Durchführung des erfindungsgemäßen Verfahrens zur Identifizierung dieser integrierten Schaltung. Die integrierte Schaltung enthält einen Speicher 1, vorzugsweise einen Halbleiterspeicher. Der Speicher 1 besteht aus zwei Speicherbereichen, nämlich einem gewöhnlichen, primär adressierbaren Speicherbereich 1a und einem redundanten Speicherbereich 1b. Der Speicher 1 ist über mehreren Wortleitungen 2 mit einer Adressen-Decodierschaltung 3 verbunden. An der Adressen-Decodierschaltung 3 liegt ein Adressenbus 4 der integrierten Schaltung an. Zusätzlich ist die Adressen-Decodierschaltung 3 über Leitungen 5 mit einem Adressenumsetzungsspeicher 6 verbunden. In dem gewöhnlichen Speicherbereich la treten herstellungsbedingt fehlerhafte Speicherzellen, beispielsweise drei fehlerhafte Speicherzellen 7, 8, 9 auf. In dem Adressenumsetzungsspeicher 6 wird zu jeder Adresse einer der fehlerhaften Speicherzellen 7, 8, 9 in dem Speicherbereich 1a jeweils eine Adresse einer zugehörigen Ersatzspeicherzelle 10, 11, 12 in dem redundanten Speicherbereich 1b abgespeichert. Dabei wird eine Adressentabelle in dem Adressenumsetzungsspeicher angelegt, in der zu jeder Adresse einer fehlerhaft erkannten Speicherzelle 7, 8, 9 jeweils eine zugehörige Ersatzspeicherzelle 10, 11, 12 abgespeichert wird. Wird über den Adreßbus 4 die Adresse einer fehlerhaften Speicherzelle an die Adressen-Decodierschaltung 3 angelegt, leitet die Adressen-Decodierschaltung 3 nach Zugriff auf den Adressenumsetzungsspeicher 6 diese Adresse auf die Adresse der zugehörigen redundanten Ersatzspeicherzelle in dem redundanten Speicherbereich 1b des Speichers 1 um.

Die Adressenumsetzung wird entweder noch während des Herstellungsprozesses der integrierten Schaltung durch Fusen bzw. Festverdrahten des Adressenumsetzungsspeichers in der integrierten Schaltung implementiert oder der Adressenumsetzungsspeicher wird bei jedem Einschalten der integrierten Schaltung nach Durchführung eines Selbsttests neu über den Speicherzugriff umprogrammiert.

Bei der Implementierung der Adressenumsetzung während des Herstellungsprozesses werden die Adressen der fehlerhaften Speicherzellen 7, 8, 9 in dem gewöhnlichen Speicherbereich nach der Herstellung der integrierten Schaltung in einem von dem Hersteller durchgeführten Test einmalig erfaßt und mit den Adressen von zugewiesenen Ersatzspeicherzellen 10, 11, 12 in dem Adressenumsetzungsspeicher 6 zur Adressenumleitung fest abgespeichert bzw. gefused.

Falls beim Einschalten der integrierten Schaltung ein Selbsttest des Speichers erfolgt, werden die Adressen der fehlerhaften Speicherzellen 7, 8, 9 bei jedem Einschalten der integrierten Schaltung in einem Selbsttest erfaßt und mit einer Adresse einer zugewiesenen Ersatzspeicherzelle 10, 11, 12 in dem Adressenumsetzungsspeicher 6 zur Adressenumleitung abgespeichert.

Die fehlerhaften Speicherzellen 7, 8, 9 in dem Speicherbereich la des Speichers 1 bilden ein charakterisierendes Speicherzellen-Fehlermuster zur Kennzeichnung des in der integrierten Schaltung enthaltenen Speichers 1. Bei der Herstellung der integrierten Schaltung mit großen integrierten Speichern 1, d.h. Speichern mit einer Vielzahl von Speicherzellen, treten aufgrund der Vielzahl von Speicherzellen Herstellungsfehler in den Speichern auf. Damit die integrierte Schaltung dennoch verwendbar ist, wird der redundante Speicherbereich 1b vorgesehen, der mittels Adressenumsetzung adressiert wird. Die Häufigkeit des Auftretens von fehlerhaften Speicherzellen 7, 8, 9 nimmt mit zunehmender Größe des Speicherbereichs 1a zu. Gleichzeitig steigt die Häufigkeit von fehlerhaften Speicherzellen mit der zunehmenden Empfindlichkeit des Herstellungsprozesses, insbesondere mit zunehmendem Miniaturisierungsgrad bei der Integration des Speichers.

Bei der derzeit kleinsten im GSM-Bereich verwendeten Speichergröße von 128 kB weisen die Adressen der Speicherzellen 17 bit Länge auf. Damit können 2¹⁷ verschiedene fehlerhafte integrierte Schaltungen unterschieden werden. Mit zunehmender Speichergröße nimmt die statistische Wahrscheinlichkeit, daß keine Speicherzelle in dem Speicherbereich la fehlerhaft ist, ab. Bei den gewöhnlich eingesetzten Speichern und den derzeitig verwendeten Herstellungstechnologien ist die Wahrscheinlichkeit, daß keine fehlerhafte Speicherzelle in dem Speicherbereich la auftritt, sehr gering. Ein Speicherbereich la ohne eine einzige fehlerhafte Speicherzelle weist somit ebenfalls ein für ihn kennzeichnendes Fehlermuster auf, nämlich das besondere Fehlermuster, daß keine einzige Speicherzelle fehlerhaft ist.

Die in dem Speicherbereich la auftretenden fehlerhaften Speicherzellen wirken wie ein Fingerabdruck des Speichers 1 und somit auch der integrierten Schaltung, in welcher der Speicher 1 enthalten ist.

Im erfindungsgemäßen Verfahren zur Identifizierung einer integrierten Schaltung wird das aus den fehlerhaften Speicherzellen gebildete Speicherzellen-Fehlermuster zur Erzeugung einer Schaltungsidentifizierungsnummer zur Identifizierung der integrierten Schaltung benutzt. Die Schaltungsidentifizierungsnummer der integrierten Schaltung wird dabei vorzugsweise in Abhängigkeit von den Adressen der fehlerhaften Speicherzellen 7, 8, 9 erzeugt.

Dabei kann die charakterisierende Schaltungsidentifizierungsnummer der integrierten Schaltung aus einer oder mehrerer Adressen der fehlerhaften Speicherzellen 7, 8, 9 selbst bestehen. Alternativ dazu wird die Schaltungsidentifizierungsnummer gebildet, indem mehrere Adressen der fehlerhaften Speicherzellen 7, 8, 9 in einer Rechenoperation mathematisch miteinander verknüpft werden. Die dazu notwendige Berechnungsvorschrift wird vorzugsweise in einem Programmspeicherbereich des Speichers 1 abgespeichert.

Wie man aus Fig. 3 erkennen kann, wird kein eigenständiger Seriennummern- bzw. Schaltungsidentifizierungsnummernspeicher zum Abspeichern der Schaltungsidentifizierungsnummer benötigt.

Die erzeugte Schaltungsidentifizierungsnummer wird zur Verknüpfung mit einem Geräteprogramm zu einem ablauffähigen Geräteprogramm ausgelesen. Hierzu erhält ein Gerätehersteller, in dessen Geräte die hergestellte integrierte Schaltung eingebaut wird, von dem Hersteller der integrierten Schaltung ein Ausleseprogramm zum Auslesen der Schaltungsidentifizierungsnummer. Der Gerätehersteller, der beispielsweise Mobilfunkendgeräte oder Computer herstellt, führt das Ausleseprogramm an der integrierten Schaltung zum Auslesen der Schaltungsidentifizierungsnummer durch und verknüpft die ausgelesen Schaltungsidentifizierungsnummer mit seiner Original-Software zu einer ablauffähigen Geräte-Software. Das Gerät mit der ablauffähigen Geräte-Software wird von dem Gerätehersteller an die Endbenutzer ausgeliefert.

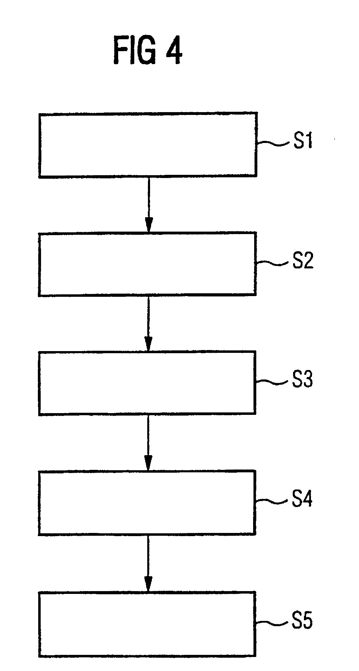

Fig. 4 zeigt in einem Ablaufdiagramm die einzelnen Schritte, die bis zur Verknüpfung der originalen Software mit der Schaltungsidentifizierungsnummer durchgeführt werden.

In einem Schritt S1 wird die integrierte Schaltung mit einem herstellungsbedingten Speicherzellen-Fehlermuster hergestellt.

Danach werden in einem Schritt S2 die Adressen der fehlerhaften Speicherzellen erfaßt.

In einem Schritt S3 wird eine Schaltungsidentifizierungsnummer für die integrierte Schaltung in Abhängigkeit von den erfaßten Adressen der fehlerhaften Speicherzellen erzeugt.

Die erzeugte Schaltungsidentifizierungsnummer wird in einem Schritt S4 durch den Gerätehersteller mittels eines ihm zugänglichen Ausleseprogramms ausgelesen.

Beim Gerätehersteller wird in einem Schritt S5 die Schaltungsidentifizierungsnummer mit einem Original-Geräteprogramm zu einem auf dem Gerät ablauffähigen Geräteprogramm verknüpft.

Danach wird das Gerät zur Benutzung an den Kunden ausgeliefert.

Bei der Benutzung durch den Kunden wird vorzugsweise bei jedem Einschalten des Gerätes ein Selbsttest durchgeführt und fehlerhafte Adressen über Adreßleitungen umgeleitet. Die Schaltungsidentifizierungsnummer wird in Abhängigkeit von den in dem Selbsttest erfaßten Adressen der fehlerhaften Speicherzellen erzeugt und durch das Geräteprogramm mit der verknüpften ursprünglichen Schaltungsidentifizierungsnummer verglichen. Das Geräteprogramm schaltet das zugehörige Gerät frei, wenn die nach dem Selbsttest erzeugte Schaltungsidentifizierungsnummer mit der ursprünglichen Schaltungsidentifizierungsnummer identisch ist. Eine "raubkopierte" Software läuft auf dem Endgerät nur, wenn die integrierte Schaltung in dem Gerät, aus dem die Software stammt, das identische Speicherzellen-Fehlermuster besitzt, wie die integrierte Schaltung von demjenigen Gerät, in die die Software kopiert werden soll. Die Wahrscheinlichkeit hierfür ist äußerst gering und geht gegen Null. Das erfindungsgemäße Verfahren ist bereits dann hinreichend sicher, wenn der Speicherbereich la nur eine einzige fehlerhafte Speicherzelle aufweist.

Bei dem erfindungsgemäßen Verfahren ist eine Festverdrahtung der Seriennummer in einem eigenen Seriennummernspeicherbereich nicht mehr erforderlich.

Wird zusätzlich in dem Endgerät beim Einschalten der integrierten Schaltung ein Selbsttest durchgeführt, ist auch eine Festverdrahtung des Adressenumsetzungsspeichers 6 nicht mehr erforderlich. In diesem Falle entfällt das Fusen bzw. Programmieren der integrierten Schaltung völlig. Hierdurch wird einerseits die durch das Festverdrahten zusätzlich benötigte Produktionszeit eingespart, und ferner braucht man keine Anlage zur Durchführung der Festverdrahtung bzw. des Fuse-Vorgangs. Hierdurch werden die Herstellungskosten der integrierten Schaltung insgesamt erheblich abgesenkt. Darüber hinaus bietet das erfindungsgemäße Verfahren eine überaus sichere Identifizierung der integrierten Schaltung.

Das erfindungsgemäße Verfahren zur Identifizierung einer integrierten Schaltung ist vielseitig einsetzbar, insbesondere in allen Bereichen, bei denen eine Original-Software des Geräteherstellers mit einer durch einen Speicherhersteller hergestellten integrierten Schaltung verknüpft wird. Typische Bereiche sind hier PC-Applikationen und Mobilfunk-Endgeräte.

Das erfindungsgemäße Verfahren kann besonders vorteilhaft bei integrierten Schaltungen eingesetzt werden, die keine nicht-flüchtigen, programmierbaren Speicherbereiche, wie PROM oder Flash-EPROM aufweisen.

Das erfindungsgemäße Verfahren eignet sich insbesondere zur Identifizierung von integrierten Schaltungen mit darin enthaltenen SRAM- oder DRAM-Speichern.

Das erfindungsgemäße Verfahren kann dahingehend ausgeweitet werden, daß man das Speicherzellen-Fehlermuster im Herstellungsprozeß aktiv erzeugt. In einem Zufalls- bzw. Random-Prozeß werden dabei zufällige Speicherzellenadressen erzeugt und die zugehörigen Speicherzellen als fehlerhaft gekennzeichnet bzw. beschädigt.

## Patentansprüche

1. Verfahren zur Identifizierung einer integrierten Schaltung mit einem aus einer Vielzahl von Speicherzellen bestehenden Speicher (1), der ein herstellungsbedingtes, aus fehlerhaften Speicherzellen (7, 8, 9) bestehendes Speicherzellen-Fehlermuster aufweist, bei dem eine Schaltungsidentifizierungsnummer zur Identifizierung der integrierten Schaltung in Abhängigkeit von dem Speicherzellen-Fehlermuster erzeugt wird.

2. Verfahren nach Anspruch 1,
**dadurch gekennzeichnet,**
**daß** die Adressen der fehlerhaften Speicherzellen (7, 8, 9) erfaßt werden und die Schaltungsidentifizierungsnummer in Abhängigkeit von den Adressen der fehlerhaften Speicherzellen (7, 8, 9) erzeugt wird.

3. Verfahren nach Anspruch 1 oder 2,
**dadurch gekennzeichnet,**
**daß** die Schaltungsidentifizierungsnummer aus einer oder mehreren Adressen der fehlerhaften Speicherzellen (7, 8, 9) gebildet wird.

4. Verfahren nach Anspruch 1 oder 2,
**dadurch gekennzeichnet,**
**daß** die Schaltungsidentifizierungsnummer erzeugt wird, indem mehrere Adressen der fehlerhaften Speicherzellen (7, 8, 9) in einem Berechnungsvorgang zur Erzeugung der Schaltungsidentifizierungsnummer verknüpft werden.

5. Verfahren nach einem der vorangehenden Ansprüche,
**dadurch gekennzeichnet,**
**daß** die Schaltungsidentifizierungsnummer zur Verknüpfung mit einem Geräteprogramm zu einem ablauffähigen Geräteprogramm ausgelesen wird.

6. Verfahren nach Anspruch 5,
**dadurch gekennzeichnet,**
**daß** das verknüpfte ablauffähige Geräteprogramm zum Betreiben eines Geräts in einem Programmspeicherbereich abgespeichert wird.

7. Verfahren nach einem der vorangehenden Ansprüche,
**dadurch gekennzeichnet,**
**daß** die Adresse jeder fehlerhaften Speicherzelle (7, 8, 9) jeweils auf eine Adresse einer Ersatzspeicherzelle (10, 11, 12) in einem redundanten Speicherbereich (1b) des Speichers (1) umgeleitet wird.

8. Verfahren nach einem der vorangehenden Ansprüche,
**dadurch gekennzeichnet,**
**daß** zu jeder Adresse einer fehlerhaften Speicherzelle (7, 8, 9) jeweils die Adresse einer zugehörigen Ersatzspeicherzelle (10, 11, 12) in einem Adressenumsetzungsspeicher (6) als Adressentabelle abgespeichert wird.

9. Verfahren nach einem der vorangehenden Ansprüche,
**dadurch gekennzeichnet,**
**daß** die Adressen der fehlerhaften Speicherzellen (7, 8, 9) nach der Herstellung der integrierten Schaltung in einem Herstellertest einmalig erfaßt werden und mit den Adressen der zugehörigen Ersatzspeicherzellen (10, 11, 12) in dem Adressenumsetzungsspeicher (6) zur Adressenumleitung fest abgespeichert werden.

10. Verfahren nach einem der vorangehenden Ansprüche 1 bis 8,
**dadurch gekennzeichnet,**
**daß** die Adressen der fehlerhaften Speicherzellen (7, 8, 9) bei jedem Einschalten der integrierten Schaltung in einem Selbsttest erfaßt und mit den Adressen der zugehörigen Ersatzspeicherzellen (10, 11, 12) in dem Adressenumsetzungsspeicher (6) zur Adressenumleitung abgespeichert werden.

11. Verfahren nach Anspruch 10,
**dadurch gekennzeichnet,**
**daß** die Schaltungsidentifizierungsnummer in Abhängigkeit von den in dem Selbsttest erfaßten Adressen der fehlerhaften Speicherzellen (7, 8, 9) erzeugt wird und durch das Geräteprogramm mit der verknüpften ursprünglichen Schaltungsidentifizierungsnummer verglichen wird, wobei das Geräteprogramm das zugehörige Gerät freischaltet, wenn die nach dem Selbsttest erzeugte Schaltungsidentifizierungsnummer mit der ursprünglichen Schaltungsidentifizierungsnummer identisch ist.

## Claims

1. Method for identifying an integrated circuit having a memory (1) which is composed of a multiplicity of memory cells and which has a manufacture-related memory cell defect pattern which is composed of defective memory cells (7, 8, 9), in which method a circuit identification number for identifying the integrated circuit is generated as a function of the memory cell defect pattern.

2. Method according to Claim 1, **characterized in that** the addresses of the defective memory cells (7, 8, 9) are acquired and the circuit identification number is generated as a function of the addresses of the defective memory cells (7, 8, 9).

3. Method according to Claim 1 or 2, **characterized in that** the circuit identification number is formed from one or more addresses of the defective memory cells (7, 8, 9).

4. Method according to Claim 1 or 2, **characterized in that** the circuit identification number is generated by linking a plurality of addresses of the defective memory cells (7, 8, 9) in a calculation operation to generate the circuit identification number.

5. Method according to one of the preceding claims, **characterized in that** the circuit identification number is read out for linking to an equipment program to form an executable equipment program.

6. Method according to Claim 5, **characterized in that** the linked executable equipment program is stored in a program memory area in order to operate a piece of equipment.

7. Method according to one of the preceding claims, **characterized in that** the address of any defective memory cell (7, 8, 9) is diverted in each case to an address of a backup memory cell (10, 11, 12) in a redundant memory area (1b) of the memory (1).

8. Method according to one of the preceding claims, **characterized in that**, for each address of a defective memory cell (7, 8, 9), in each case the address of an associated backup memory cell (10, 11, 12) is stored in an address conversion memory (6) as an address table.

9. Method according to one of the preceding claims, **characterized in that** the addresses of the defective memory cells (7, 8, 9) are acquired once after manufacture of the integrated circuit in a manufacturer test and are permanently stored with the addresses of the associated backup memory cells (10, 11, 12) in the address conversion memory (6) for address diversion.

10. Method according to one of the preceding Claims 1 to 8, **characterized in that** the addresses of the defective memory cells (7, 8, 9) are acquired in a self test whenever the integrated circuit is switched on and are stored with the addresses of the associated backup memory cells (10, 11, 12) in the address conversion memory (6) for address diversion.

11. Method according to Claim 10, **characterized in that** the circuit identification number is generated as a function of the addresses, acquired in the self test, of the defective memory cells (7, 8, 9) and is compared with the linked original circuit identification number by the equipment program, the equipment program enabling the associated piece of equipment if the circuit identification number generated in accordance with the self test is identical to the original circuit identification number.

## Revendications

1. Procédé d'identification d'un circuit intégré comportant une mémoire (1) qui est constituée d'une multiplicité de cellules de mémoire et qui a une configuration d'erreur de cellules de mémoire conditionnée par la fabrication et constituée de cellules de mémoire défectueuses (7, 8, 9), dans lequel on produit un numéro d'identification de circuit pour l'identification du circuit intégré en fonction de la configuration d'erreur de cellules de mémoire.

2. Procédé selon la revendication 1,
**caractérisé par le fait qu'**on détecte les adresses des cellules de mémoire défectueuses (7, 8, 9) et on produit le numéro d'identification de circuit en fonction des adresses des cellules de mémoire défectueuses (7, 8, 9).

3. Procédé selon la revendication 1 ou 2,
**caractérisé par le fait qu'**on forme le numéro d'identification de circuit à partir d'une ou plusieurs adresses des cellules de mémoire défectueuses (7, 8, 9).

4. Procédé selon la revendication 1 ou 2,
**caractérisé par le fait qu'**on produit le numéro d'identification de circuit en combinant plusieurs adresses des cellules de mémoire défectueuses (7, 8, 9) dans une opération de calcul pour produire le numéro d'identification de circuit.

5. Procédé selon l'une des revendications précédentes,
**caractérisé par le fait qu'**on lit le numéro d'identification de circuit pour la combinaison avec un programme d'appareil pour donner un programme d'appareil exécutable.

6. Procédé selon la revendication 5,
**caractérisé par le fait qu'**on mémorise le programme d'appareil exécutable combiné pour l'exploitation d'un appareil dans une zone de mémoire de programme.

7. Procédé selon l'une des revendications précédentes,
**caractérisé par le fait qu'**on dévie l'adresse de chaque cellule de mémoire défectueuse (7, 8, 9) à chaque fois sur une adresse d'une cellule de mémoire de remplacement (10, 11, 12) dans une zone de mémoire redondante (1b) de la mémoire (1).

8. Procédé selon l'une des revendications précédentes,
**caractérisé par le fait que**, pour chaque adresse d'une cellule de mémoire défectueuse (7, 8, 9), on mémorise respectivement l'adresse d'une cellule de mémoire de remplacement associée (10, 11, 12) dans une mémoire de conversion d'adresse (6) servant de tableau d'adresses.

9. Procédé selon l'une des revendications précédentes,
**caractérisé par le fait qu'**on détecte une fois les adresses des cellules de mémoire défectueuses (7, 8, 9) après la fabrication du circuit intégré lors d'un test de fabricant et on les mémorise avec les adresses des cellules de mémoire de remplacement associées (10, 11, 12) dans la mémoire de conversion d'adresse (6) en vue de la déviation d'adresse.

10. Procédé selon l'une des revendications 1 à 8,
**caractérisé par le fait qu'**on détecte les adresses des cellules de mémoire défectueuses (7, 8, 9) lors de chaque branchement du circuit intégré lors d'un test automatique et on les mémorise avec les adresses des cellules de mémoire de remplacement associées (10, 11, 12) dans la mémoire de conversion d'adresse (6) en vue de la déviation d'adresse.

11. Procédé selon la revendication 10,
**caractérisé par le fait qu'**on produit le numéro d'identification de circuit en fonction des adresses, détectées lors du test automatique, des cellules de mémoire défectueuses (7, 8, 9) et on le compare au moyen du programme d'appareil au numéro d'identification de circuit initial combiné, le programme d'appareil débloquant l'appareil associé si le numéro d'identification de circuit produit après le test automatique est identique au numéro d'identification de circuit initial.
